# EUROPEAN PATENT APPLICATION

(11) **EP 2 315 269 A1**
(43) Date of publication of application: **27.04.2011**
(21) Application number: 09173964.9
(22) Date of filing: 23.10.2009
(51) Int. Cl.: H01L 33/10, H01L 33/20, H01L 33/46

(54) **Light emitting diode**

(71) Applicant: NXP B.V., 5656 AG Eindhoven (NL)
(72) Inventor: Kramer, Mark, Redhill, Surrey RH1 1DL (GB); Madakasira, Vijayaraghavan, Redhill, Surrey RH1 1DL (GB)
(74) Representative: Burton, Nick

(57) **Abstract**

A light emitting diode (LED) and a method for making the same. The LED includes a semiconductor body, an active region positioned at a surface of the semiconductor body, and a reflector located beneath the active region in the semiconductor body. The reflector improves the external quantum efficiency of the LED by reflecting light, emitted by the active region, through the surface of the semiconductor body.

## Description

### BACKGROUND OF THE INVENTION

This invention relates to light emitting diodes (LEDs). In particular, this invention relates to improving the external quantum efficiency (EQE) of LEDs.

The EQE of an LED is, in general, a measure of its efficiency in terms of the amount of light emitted by the LED for a given amount of electrical power provided. It is known that a number of different factors contribute to losses within an LED. Each of these factors has a detrimental effect upon the LEDs EQE.

A first source of losses within an LED is associated with the fact that not all of the photons generated within an LED travel toward the surface of the LED for emission.

Another source of losses is associated with the fact that upon reaching the surface of the LED, some photon be reflected, and are therefore not emitted.

A related source of losses arises from the re-absorption of photons within an LED. Photons that do not travel to the surface of the LED for emission and/or photons that are reflected by the surface as described above are generally reabsorbed. However, some photons which would otherwise be emitted by the LED may also be absorbed on their journey toward the LED surface.

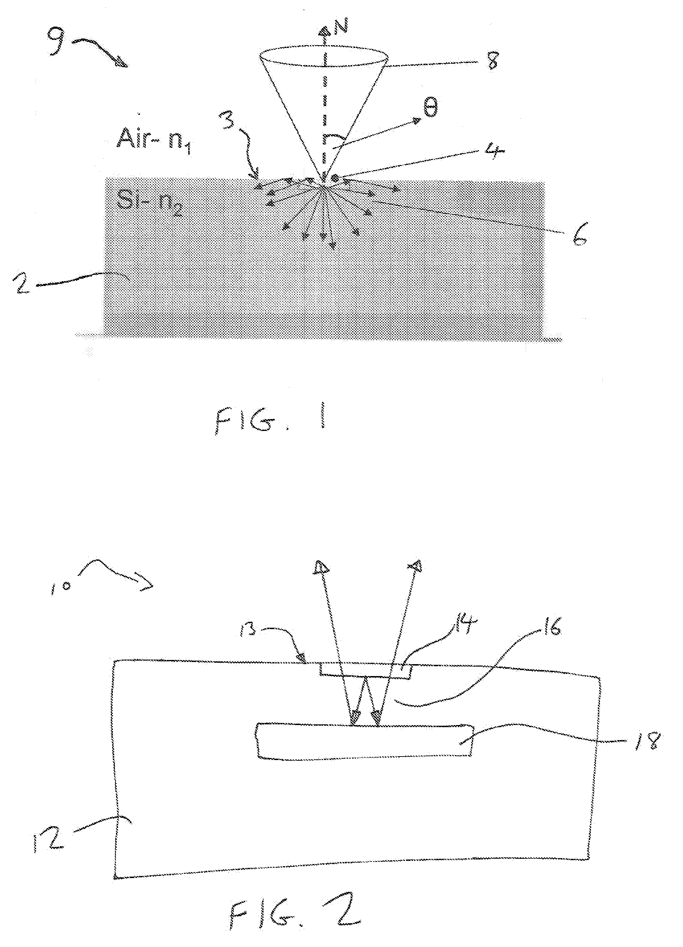

The sources of photon loss described above are illustrated in Figure 1, in relation to a known kind of LED.

The LED 9 shown in Figure 1 includes a silicon substrate 2 having a surface 3. An active region 4 of the LED is provided at the surface 3 of the substrate 2.

During normal operation of the LED 9, the active region 4 emits light, much of which exits the surface 3 of the substrate 2. The light is emitted over a range of angles θ, measured from the surface normal N. As shown in Figure 1, the angle θ defines a cone 8 around the surface normal N, extending from the surface 3.

Figure 1 illustrates that at least some of the photons travel along paths 6 which take those photons away from the surface 3. Other photons have paths 6 which show them to be reflected at the surface 3.

The power provided to generate photons that are not emitted by the LED is lost, and does not contribute to the emission characteristic of the LED. This leads to a corresponding reduction in EQE.

### SUMMARY OF THE INVENTION

Particular and preferred aspects of the invention are set out in the accompanying independent and dependent claims. Combinations of features from the dependent claims may be combined with features of the independent claims as appropriate and not merely as explicitly set out in the claims.

According to an aspect of the invention, there is provided a light emitting diode (LED) including a semiconductor body. The LED also includes an active region positioned at a surface of the semiconductor body. The LED further includes a reflector located beneath the active region in the semiconductor body. The reflector is for improving the external quantum efficiency of the diode by reflecting light that emitted by the active region. The light is reflected through the surface of the semiconductor body.

According to another aspect of the invention, there is provided a method of making a light emitting diode having improved external quantum efficiency. The method includes providing a semiconductor body. The method also includes etching an opening in a surface of the semiconductor body. The method further includes providing a reflector within the opening. The method also includes refilling the opening in the semiconductor body with a semiconductor material. The method further includes providing an active region of the light emitting diode at the surface of the refilled portion of the semiconductor body, above the reflector.

The provision of the reflector allows light that would normally be lost within the LED to be reflected back through the surface of the substrate, thereby improving the EQE of the LED. Since the reflector is provided within the substrate, it can be positioned in proximity to the active region. This improves the efficiency of the reflector as compared to known devices in which a reflector is provided externally to the substrate. It may also negate the need for an external reflector. Moreover, the methods described herein can be implemented using standard wafer processing techniques.

The reflector can take the form of a buried layer of material having a refractive index that is different to a refractive index of the remainder of the semiconductor body. In one example, the reflector can include a layer of metal, such as Tungsten.

The reflector can, in some examples, be shaped to direct (or even focus) the reflected light in a specific direction. For example, the reflector may be concave. The actual shape of the reflector can be chosen in accordance with the intended use of the LED. For example, some LED applications require a directional light output. For such applications, the reflector may be chosen to be hemispherical. For the production of light focused on a certain distance, the reflector can have cross section of part of an ellipsoid. Other shapes, such as parabolic, or faceted are also envisaged.

In some examples, the reflector can enclose a volume of the semiconductor body around the active region. In this way, the coverage of the reflector can be maximised.

To etch the opening in the surface of the semiconductor body, a mask can be provided on the surface. The opening can be etched via a corresponding aperture in the mask. The aperture in the mask can, in one embodiment, be substantially smaller than the intended opening. In such an embodiment, the etchant radiates outward from the aperture to form an opening having a curved surface (e.g. substantially hemispherical).

The reflector can be provided by means of a sacrificial layer. For example, a sacrificial layer can be provided in the opening in the surface of the semiconductor body, prior to refilling the opening. Subsequent to refilling the opening, the sacrificial layer can be removed and replaced with the reflector. The sacrificial layer can comprise, for example, a selectively etchable material such as: an oxide; doped materials such as SiGe; or amorphous materials such as amorphous Si (using an ion implantation step to produce a damaged layer).

### BRIEF DESCRIPTION OF THE DRAWINGS

Embodiments of the present invention will be described hereinafter, by way of example only, with reference to the accompanying drawings in which like reference signs relate to like elements and in which:
Figure 1 shows a light emitting diode according to the state of the art;
Figure 2 shows a light emitting diode according an embodiment of the invention;
Figure 3 shows another light emitting diode according an embodiment of the invention; and
Figure 4A-4H show an example method of making a light emitting diode according to an embodiment of the invention.

### DETAILED DESCRIPTION

Embodiments of the present invention are described in the following with reference to the accompanying drawings.

Figure 2 schematically illustrates a first embodiment of the invention. In accordance with this embodiment, there is provided an LED 10. The LED 10 can incorporated into a larger LED assembly. For example, the semiconductor body 12 may be mounted in an LED housing, which may itself comprise reflectors placed around the LED to capture and direct light.

The LED 10 includes a semiconductor body 12 which may, for example, comprise a portion of semiconductor material such as a semiconductor die cut from a larger wafer join manufacture. The semiconductor body 12 can comprise any suitable semiconductor material such as, for example, silicon.

The LED 10 includes an active region 14, which is provided at a surface 13 of the semiconductor body 12. The active region 14 may be any conventional LED active region, and may be manufactured in accordance with known processes and techniques.

As shown in Figure 2, the LED 10 further includes a reflector 18. The reflector 18 is located beneath the active region 14 in the semiconductor body 12. In this example, the active region comprises a substantially planar layer positioned beneath the active region 14. As is shown in Figure 2, some of the light that is emitted by the active region 14 may travel downwards into the bulk of the semiconductor body 12, along paths 16. This light can be reflected, by the reflector 18, back through and out of the surface 13 of the semiconductor body 12. In Figure 2 it is shown that the paths 16 pass back through the active region 14, however it will be appreciated that this is not essential to the invention, and that light reflected by the reflector 18 back through the surface 13 may pass adjacent to the active region 14 and not actually pass through the active region 14 itself.

Light that is reflected back through the surface 13 by the reflector 18 can contribute to the overall output of the LED 10, thereby mitigating at least some of the losses within the LED 10 due to absorption and surface reflection. This in turn can result in an increased EQE as compared to known LEDs.

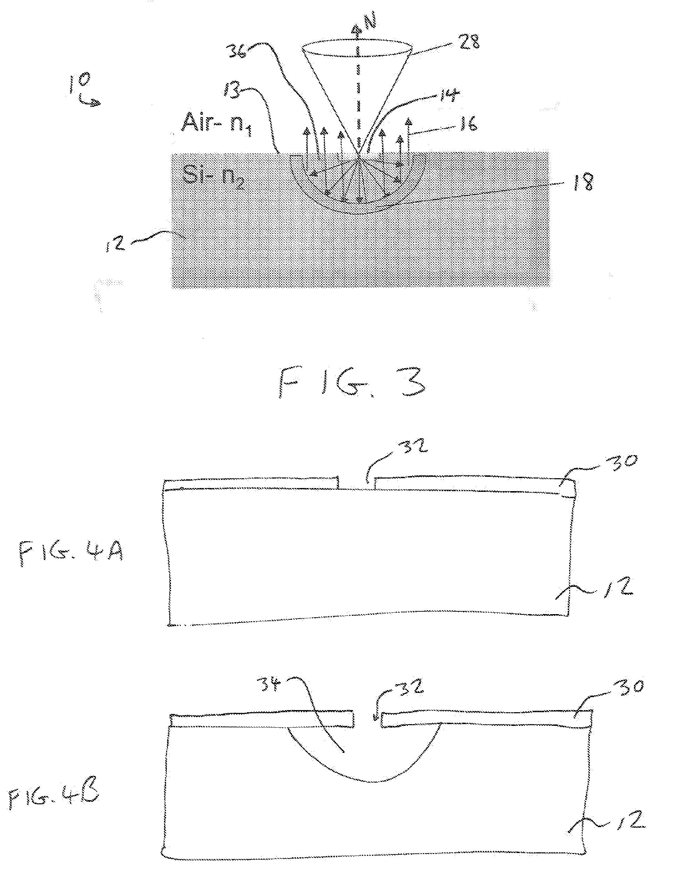

Another example of an LED 10 in accordance with this invention is shown in Figure 3. This second embodiment of an LED 10 also includes a semiconductor body 12 of the kind described above in relation to Figure 2. Also in common with the first embodiment, this second embodiment includes an active region 14, which is provided at a surface 13 of the semiconductor body 12. As before, the active region 14 may comprise any suitable active region, such as those already known in the art. In this embodiment, there is provided a reflector 18, which in contrast to the substantially planar reflector of the first embodiment, is concave. This concave configuration can allow the reflector 18 to reflect light in a concentrated fashion, unlike the reflections produced by a substantially planar reflector 18 of the kind described in relation to Figure 2.

In the particular example shown in Figure 3, the reflector 18 is substantially hemispherical. As described above, the actual shape of the reflected can be chosen in accordance with the intended use of the LED. Hemispherical, ellipsoidal, parabolic and faceted cross sections are all envisaged.

As shown in Figure 3, the substantially hemispherical cross-section of the reflector 18 causes light emitted by the active region 14 to be reflected in a common direction, substantially independently of the initial direction of the light path 18 as it leaves the active region 14. In this way, a more concentrated beam is produced by the LED 10. In this particular example, the light paths 16 produced by light reflected by the reflector 18 are substantially parallel to the surface normal N of the surface 13. However, it is envisaged that reflected light may be concentrated in a direction other than that parallel to the surface normal N.

In the present example, it can be seen that the concave reflector 18 encloses a volume of the semiconductor body 10 around the active region 14. This volume is denoted with reference numeral 36 in Figure 3. It will be appreciated that the volume 36 may comprise the same material as the remainder of the semiconductor body 12. Alternatively, a different material may be used, in accordance with design requirements.

In both of the embodiments described above, the reflector 18 typically comprises a material which has a refractive index which differs from the refractive index of the semiconductor body 12. Hence, the difference in refractive indices between the reflector and the semiconductor body 12 can allow total external reflection to take place at the surface of the reflector 18, for directing light back through the surface 13 of the semiconductor body 12.

Any suitable material may be chosen for the reflector 18. By way of example only, the reflector 18 may comprise a metal provided in the form of a buried metal layer. In one example, the metal layer comprises Tungsten, although other metals may be used as appropriate.

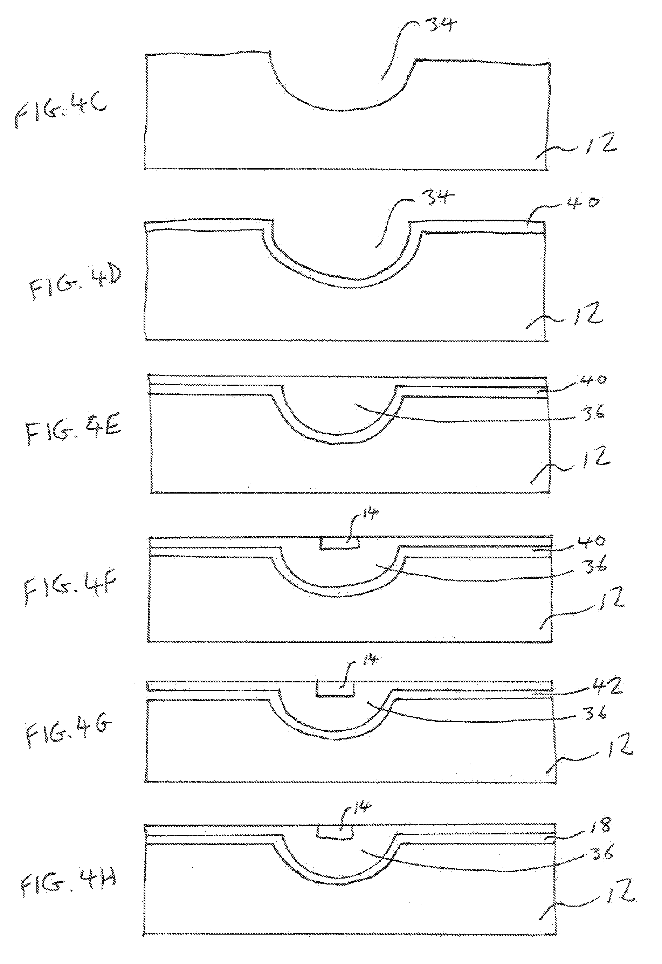

An example method for making an LED in accordance with an embodiment of this invention will now be described in relation to Figure 4.

In a first stage of a method in accordance with an embodiment of this invention, there is provided a semiconductor body 12. The semiconductor body 12 may, as described above, comprise any suitable semiconductor material, such as silicon. As is shown in Figure 4a, the semiconductor body 12 is provided at an upper surface thereof with a mask 30 having an opening 32. In this example, the opening 32 corresponds in position to the eventual position of the active region 14 which is to be formed in the semiconductor body 12 as described below. However, the purpose of the opening is to allow etching of the semiconductor body 12, and therefore it is not completely essential that the opening 32 be provided in a position corresponding to the eventual location of the active region 14.

The mask 30 and the opening 32 may, for example, be provided using one or more photolithography steps in a manner that is known in the art.

In a second stage of the method, and as shown in Figure 4b, an opening 34 is etched into the semiconductor body 12. The etching takes place through the opening 32 in the mask 30. Any suitable etchant may be used for etching the semiconductor body 12, and the selection may typically depend upon the material from which the semiconductor body 12 is made.

In this example, the lateral dimension of the opening 32 in the mask 30 is relatively small. Because of this, the etched opening 34 tends to take on a concave shape, such as a hemispherical shape of the kind described above in relation to the second embodiment (Figure 3). Thus, the surface of the opening 34 is curved, as the etchant works radially away from the opening 32.

As shown in Figure 4c, following the etching of the opening 34, the mask 30 is removed.

In Figure 4d, it is shown that a next stage of the method includes the deposition of a reflective layer 40. As described above, the reflective layer 40 typically has a refractive index which differs from the refractive index of the semiconductor body 12. In one example, the layer 40 comprises a metallic material such as tungsten. The layer 40 is deposited on a surface of the opening 34 and may also cover portions of the surface of the semiconductor body 12 outside the opening 34, as shown in Figure 4d.

After deposition of the layer 40, the opening 34 is refilled, to form a refilled portion 36 of the semiconductor body 12. The material used to refill the opening may comprise the same material as the material of the semiconductor body 12, or may alternatively comprise a different material.

Thereafter, an active region 14 can be manufactured in the refilled portion 36 of the semiconductor body 12 in accordance with conventional techniques and methods.

In the presently described example, the layer 40 thus forms the reflective layer beneath the active region 14, and the final construction of the LED is substantially that of the LED described above in relation to Figure 3.

In a separate example, the layer 40 may be a sacrificial layer, which is subsequently removed after formation of the refilled portion 36 and/or the active region 14. As shown in Figure 4g, the sacrificial layer can be removed to form a cavity 42 beneath the active region 14. As shown in Figure 4h, the cavity 42 can subsequently be filled in with a reflective layer 18. Any suitable material may be used for the sacrificial layer, such as a selectively etchable material such as: an oxide; doped materials such as SiGe; or amorphous materials such as amorphous Si (using ion implantation to produce a damaged surface layer constituting the sacrificial layer 40, prior to refilling the opening 34). As described above, the material used to refill the cavity 42 may comprise any suitable reflective material having a refractive index that differs from the refractive index of the semiconductor body 12. Since the sacrificial layer 40 is to be removed before completion of the LED 10, its refractive index is, of course, not important.

Alternative methods for forming an LED in accordance with this invention are envisaged.

For example, and as described above in relation to Figure 2, the reflector 18 need not be curved, concave or hemispherical, and may be substantially planar. It is envisaged that an LED 10 of the kind described in Figure 2 could be made by forming a layered structure in which the reflector 18 forms a buried layer beneath the surface 13 of the semiconductor body 12. The reflector 18 could then be covered with further semiconductor material, and the active region 14 could then subsequently be provided within the material that covers the reflector 18.

Accordingly, there has been described a light emitting diode (LED) and a method for making the same. The LED includes a semiconductor body, an active region positioned at a surface of the semiconductor body, and a reflector located beneath the active region in the semiconductor body. The reflector improves the external quantum efficiency of the LED by reflecting light, emitted by the active region, through the surface of the semiconductor body.

Although particular embodiments of the invention have been described, it will be appreciated that many modifications/additions and/or substitutions may be made within the scope of the claimed invention.

## Claims

1. A light emitting diode comprising:
a semiconductor body;
an active region positioned at a surface of the semiconductor body; and
a reflector located beneath the active region in the semiconductor body, for improving the external quantum efficiency of the diode by reflecting light, emitted by the active region, through the surface of the semiconductor body.

2. The light emitting diode of claim 1, wherein the reflector comprises a buried layer of material having a refractive index that is different to a refractive index of the remainder of the semiconductor body.

3. The light emitting diode of claim 1 or claim 2, wherein the reflector comprises a metal layer.

4. The light emitting diode of any preceding claim, wherein the reflector is concave.

5. The light emitting diode of claim 4, wherein the reflector is hemispherical.

6. The light emitting diode of claim 4 or claim 5, wherein the reflector encloses a volume of the semiconductor body around the active region.

7. A method of making a light emitting diode having improved external quantum efficiency, the method comprising:
providing a semiconductor body;
etching an opening in a surface of the semiconductor body;
providing a reflector within the opening;
refilling the opening in the semiconductor body with a semiconductor material; and
providing an active region of the light emitting diode at the surface of the refilled portion of the semiconductor body, above the reflector.

8. The method of claim 7, wherein said etching an opening in the surface of the semiconductor body comprises:
providing a mask on said surface;
etching the opening via a corresponding aperture in the mask,; and
removing the mask.

9. The method of claim 7 or claim 8, wherein providing the reflector comprises:
providing a sacrificial layer in the opening in the surface of the semiconductor body, prior refilling the opening; and
subsequent to refilling the opening, removing the sacrificial layer and replacing it with the reflector.

10. The method of claim 9, wherein the sacrificial layer comprises a selectively etchable material, and wherein removing the sacrificial layer comprises selectively etching the sacrificial layer.

11. The method of claim 10, wherein the selectively etchable material comprises SiGe.

12. The method of any of claims 7 to 11, wherein the reflector comprises a metal layer.

13. The method of any of claims 7 to 12, wherein the reflector is concave.

14. The method of claim 13, wherein the reflector is hemispherical.

15. The method of claim 13 or claim 14, wherein the reflector encloses a volume of the semiconductor body around the active region.
